# EUROPEAN PATENT APPLICATION

(11) **EP 2 716 718 A1**
(43) Date of publication of application: **09.04.2014**
(21) Application number: 12794115.1
(22) Date of filing: 04.06.2012
(51) Int. Cl.: C08L 101/00, B32B 15/092, B32B 27/18, B32B 27/38, C08K 3/18, C08L 21/00, C08L 85/02, C09J 163/00, C09J 185/02, H05K 3/38

(54) **FIRE-RETARDANT RESIN COMPOSITION, METAL-CLAD BASE LAMINATE FOR FLEXIBLE PRINTED CIRCUIT BOARD UTILIZING SAID COMPOSITION, COVER LAY, ADHESIVE SHEET FOR FLEXIBLE PRINTED CIRCUIT BOARD AND FLEXIBLE PRINTED CIRCUIT BOARD**

(30) Priority: 03.06.2011 JP 2011125437
(71) Applicant: ARISAWA MFG. CO., LTD., Joetsu-shi, Niigata 943-8610 (JP)
(72) Inventor: DOBASHI, Shu, Joetsu-shi Niigata 9438610 (JP); TOYAMA, Yuji, Joetsu-shi Niigata 9438610 (JP); KOIKE, Tsuneo, Joetsu-shi Niigata 9438610 (JP); TAI, Makoto, Joetsu-shi Niigata 9438610 (JP); LEBEL, Marc-Andre, Boxborough, Massachusetts 01719 (US); LENS, Jan-Pleun, Boston, Massachusetts 02118 (US)
(74) Representative: Müllejans, Inge
(86) International application number: PCT/JP2012/064859
(87) International publication number: WO 2012/165665

(57) **Abstract**

(PROBLEM) To provide a flame-retardant resin composition that has superior adhesion subsequent to curing and molding when used as a printed wiring board adhesive and that provides superior printed wiring board electrical characteristics; and a flexible printed wiring board metal-clad laminate, a coverlay, a flexible printed wiring board adhesive sheet, and a flexible printed wiring board employing this resin composition. (SOLUTION) The flame-retardant resin composition comprises a thermosetting resin, a hardener, and a phosphorus-containing polymer.

## Description

### (TECHNOLOGICAL FIELD)

The present invention relates to a halogen-free flame-retardant resin composition. More specifically, in the field of electronic materials, the present invention relates to a composite composed of glass fiber and to a flame-retardant resin composition that is primarily used in adhesives for polyimide, metal foil, and the like, as well as a flexible printed wiring board metal-clad laminate, a coverlay, an adhesive sheet, and a flexible printed wiring board that are produced using these materials.

### (BACKGROUND ART)

Flame-retardant resin compositions are widely used as adhesives in the field of electronic materials (in particular, in printed wiring boards (more specifically, flexible printed wiring boards (FPCs below) that are composed of metal-clad laminates and other substrates)). These compositions are primarily used as adhesives for adhering metal foils (e.g., copper foil) with films (e.g., polyester film or polyimide film), metal foils with each other, films with each other, composites comprising glass fiber with the aforementioned metal foils, and the aforementioned composites with films.

With the objective of improving adhesive properties or heat resistance for applications such as adhesives for circuit boards, Japanese Unexamined Patent Application Publication No. 2001-002931 discloses a flame-retardant resin composition that comprises a resin having intramolecular phosphorus atoms (e.g., a phosphorus-containing polyester resin or a phosphorus-containing polyurethane resin), a phosphorus-containing compound (e.g., ammonium polyphosphate), and, as necessary, an epoxy resin, and an isocyanate compound or other hardener (Patent Literature 1: Japanese Unexamined Patent Application Publication No. 2001-002931).

However, with the flame-retardant resin composition described in that publication, the low molecular weight phosphorus-containing compound (phosphorus-based flame retardant) is contained at a specified amount, and, when the composition is to be used as an adhesive for printed wiring boards, hydrolysis of the phosphorus-containing compound by the absorbed water content is thought to cause a dramatic decrease in adhesion strength or migration characteristics. In addition, with these flame-retardant resin compositions, the characteristics (e.g., glass transition temperature or elastic modulus) of the resin composition will degrade subsequent to curing and molding, resulting in problems with insufficient manifestation of effects related to electrical characteristics and the like in the molded and cured printed wiring board. Moreover, these flame-retardant resin compositions also have problems with providing sufficient effects particularly in regard to flame retardancy and adhesion, depending on the proportion of epoxy resin and hardener with respect to phosphorus.

### (SUMMARY OF THE INVENTION)

### (PROBLEMS TO BE SOLVED BY THE INVENTION)

The invention is intended to resolve the problems with the prior art described above. Specifically, an aim of the present invention is to provide a flame-retardant resin composition that has superior adhesion subsequent to curing and molding when used as an adhesive for printed wiring boards, and also superior printed wiring board electrical characteristics.

### (MEANS FOR SOLVING THE PROBLEMS)

The present invention attains the aim described above by providing a flame-retardant resin composition that comprises a thermosetting resin, a hardener, and a phosphonate-containing polymer.

### (EFFECT OF THE INVENTION)

In accordance with the present invention, a flame-retardant resin composition is provided that has superior adhesion subsequent to curing and molding when used as a printed wiring board adhesive and also superior printed wiring board electrical characteristics. In addition, the present invention also offers a superior flexible printed wiring board metal-clad laminate, a coverlay, an adhesive sheet, and a flexible printed wiring board that are produced by using this flame-retardant resin composition.

The disclosure of the invention presented above does not list all of the necessary features of the present invention. Sub-combinations within these groups of features may also constitute the invention.

### (BRIEF DESCRIPTION OF THE DRAWINGS)

(Fig. 1) Fig. 1 is a schematic sectional view showing an embodiment (one-sided metal-clad laminate) of the metal-clad laminate pertaining to the present invention.
(Fig. 2) Fig. 2 is a schematic sectional view showing another embodiment (two-sided metal-clad laminate) of the metal-clad laminate pertaining to the present invention.
(Fig. 3) Fig. 3 is a schematic sectional view showing an embodiment of the coverlay pertaining to the present invention.
(Fig. 4) Fig. 4 is a schematic sectional view showing an embodiment (one-sided board) of the flexible printed wiring board pertaining to the present invention.
(Fig. 5) Fig. 5 is a schematic sectional view showing another embodiment (two-sided board) of the flexible printed wiring board pertaining to the present invention.
(Fig. 6) Fig. 6 is a schematic sectional view showing an example of a flex-rigid printed wiring board in which the flame-retardant resin composition pertaining to the present invention is utilized.
(Fig. 7) Fig. 7 is a schematic sectional view showing a laminate that is provided with a copper foil prior to circuit pattern formation.
(Fig. 8) Fig. 8 is an explanatory diagram (plan view) showing the circuit pattern that was used in characteristic evaluation testing for the printed wiring boards that were produced using the flame-retardant resin composition pertaining to the present invention.

### (EMBODIMENTS OF THE INVENTION)

### (Flame-retardant resin composition)

The flame-retardant resin composition of the present invention is primarily desirable for use in applications such as flexible printed wiring board metal-clad laminates, coverlays, adhesive sheets, flexible printed wiring boards, and the like. The term "flexible printed wiring board metal-clad laminate" used herein refers to a material having a film and metal foil laminated together. In addition, the term "coverlay" refers to a material that is provided in order to protect the circuitry of a flexible printed wiring board metal-clad laminate having a conductor pattern (also referred to as "circuits" below) that has been formed in a metal foil. The coverlay is provided, for example, by a means such as applying a single layer or a multilayer laminate of the resin composition on a synthetic resin film having electrical insulation properties. In addition, the term "flexible printed wiring board" refers to a board in which a coverlay has been provided over the necessary regions on a flexible printed wiring board metal-clad laminate that has circuits.

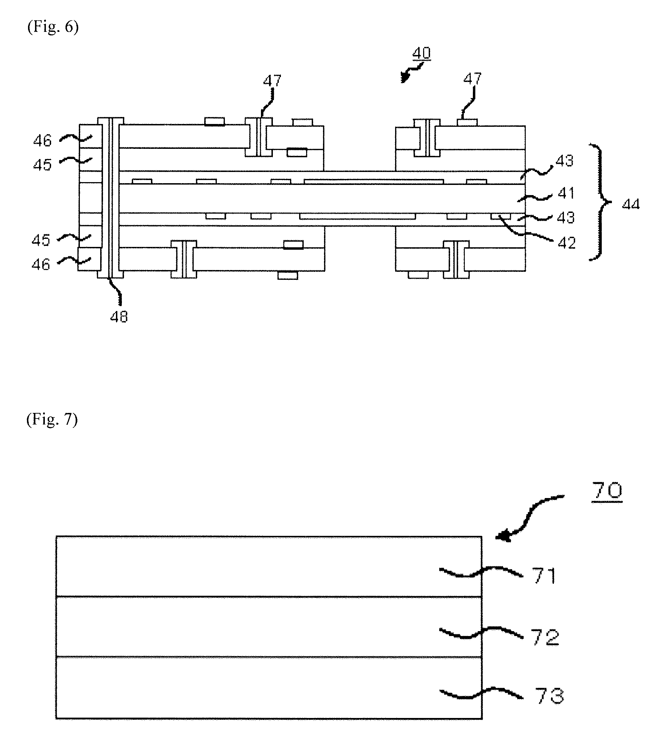

The flame-retardant resin composition of the present invention is preferably used primarily in the applications described above, but the invention can also be used in multilayer printed wiring boards, flex-rigid printed wiring boards, and the like. An example of a flex-rigid printed wiring board referred to herein that may be cited is the flex-rigid printed wiring board **40** having the configuration shown in Fig. 6. As shown in Fig. 6, the flex-rigid printed wiring board **40** has a primary configuration that comprises a copper-clad laminate **41** on which circuits **42** have been formed, an FPC **44** that is formed from a pair of coverlays **43, 43** that are laminated on both surfaces thereof, a pair of rigid substrates **46, 46** having prepreg cores that are provided on both surfaces of the FPC **44,** adhesive sheets **45, 45** that are provided between the FPC **44** and the rigid substrates **46, 46,** a plurality of circuits **47** that are formed on the surface of the rigid substrates **46, 46** by subjecting the copper foil to an etching treatment, and a through-hole **48** that is used for copper plating and is formed in predetermined circuits by a drill or the like subsequent to lamination. The "prepreg" referred to herein refers to a material that is produced by infusing glass cloth with a thermosetting resin (produced by mixing hardeners, solvents, fillers, additives, or the like with epoxy resin, BT resin, or the like), then heating and drying the material to promote a degree of curing that results in a stable state that allows storage (B-stage state).

The flame-retardant resin composition of the present invention is produced by blending a thermosetting resin, a hardener, and a phosphonate-containing polymer. The phosphonate-containing polymer is a phosphonate-containing polymer that has properties whereby it provides flame-retardancy. By blending this phosphonate-containing polymer, high flame retardancy is manifested.

In addition, the flame-retardant resin composition of the present invention comprises, as basic components, a thermosetting resin, a hardener, and a phosphonate-containing polymer or oligomer. As a result, the amount of additive for imparting flame retardancy relative to the entire resin composition can be decreased. As a result, the compatibility and mold workability of the flame-retardant resin composition prior to curing are favorable, and the adhesion characteristics and electrical characteristics of the flame-retardant resin composition subsequent to curing and molding can be improved.

Examples of the phosphonate-containing polymer that may be cited include polymers and copolymers or oligomeric versions thereof having the structural units represented by formula (1) below in the polymer main chain or in the polymer side chains.

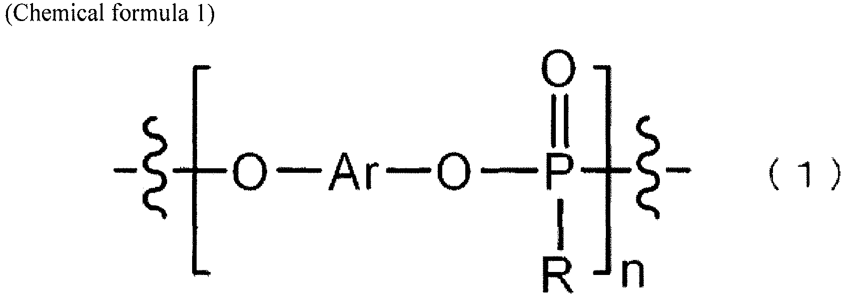

(In formula (1), Ar is an aromatic group-containing structure and -O-Ar-O- is derived from a group consisting of resorcinol, hydroquinone, biphenol, or bisphenol, R is a C1-20 alkyl, C2-20 alkene, C2-20 alkyne, C5-20 cycloalkyl, or C6-20 aryl, and n is an integer from 1 to 300, and the phosphorus in the phosphonate-containing polymer is contained at 12 wt% or less. In such embodiments, -O-Ar-O- is derived from a group consisting of bisphenol A, bisphenol F, 4,4'-bisphenol, phenolphthalein, 4,4'-thiodiphenol, 4,4'-sulfonyldiphenol, 3,3,5-trimethylcyclohexyldiphenol, and combinations thereof.)

Further specific examples of the phosphorus-containing polymer that may be cited include polymers and copolymers having the structural units represented by formula (2) below in the polymer main chain or in the polymer side chains.

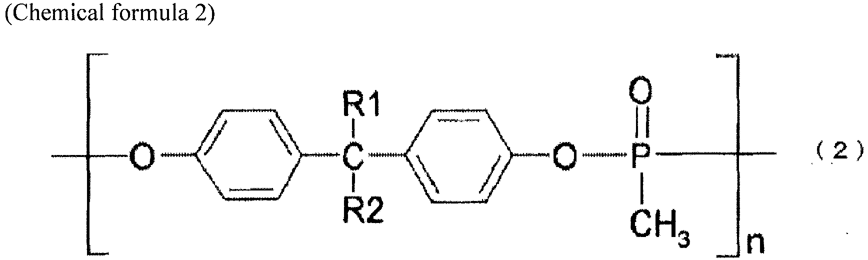

(In formula (2), R1 and R2 may be the same or different and denote hydrogen atoms, methyl groups, or lower alkyl groups and n is an integer of 50 to 300.)

The phosphorus content in the phosphonate-containing polymer is less than about 12 wt%, less than about 10 wt%, or less than about 9.5 wt%, or from about 5 wt% to about 12 wt% or about 7 wt% to about 10 wt%. The phosphonate-containing polymer exhibits a weight average molecular weight (molecular weight measured against polystyrene (polystyrene standards), the same hereinafter) of greater than about 2,500, greater than about 5,000, greater than about 9,000, greater than about 20,000, or about 2,500 to about 200,000, about 5,000 to about 150,000, or about 9,000 to about 100,000. The phosphonate-containing polymer exhibits a high Tg (glass transition temperature), where high Tg is defined as being 100°C or greater. As a result of these properties or a combination thereof, high flame retardancy effects can be manifested while using only small amounts of the phosphonate-containing polymer in the cured resin composition. Moreover, the phosphorus-containing polymer incorporates structures related to the phosphorus compounds in its main chain or in its side chains. Specifically, the structures related to the phosphorus component are protected by chemical bonding. As a result, the phosphorus component will not precipitate from the resin composition, and a flame-retardant resin composition will be produced that has excellent electrical characteristics and is resistant to hydrolysis by its water content.

The phosphonate-containing polymer or oligomer can also be a block copolymer or random copolymer (phosphonate carbonate). These copolymers (phosphonate carbonate) may include at least 20 mol% high-purity diaryl alkylphosphonate or optionally substituted diaryl alkylphosphonate, and one or more aromatic dihydroxide, wherein the mol% of the high-purity diaryl alkylphosphonate is based on the total amount of transesterification components, e.g., total diaryl alkylphosphonate and total diaryl carbonate. The term "random" means that the monomers of the copolymer (phosphonate carbonate) of various embodiments are incorporated into the polymer chain randomly. Therefore, the polymer chain may include copolymerized phosphonate and carbonate monomers alternately linked by an aromatic dihydroxide and/or various segments in which several phosphonate or several carbonate monomers form oligophosphonate or polyphosphonate or oligocarbonate or polycarbonate segments. Additionally, the length of various oligomers or polyphosphonate oligomers or polycarbonate segments may vary within individual copolymers (phosphonate carbonate).

The phosphonate and carbonate content of the copolymers (phosphonate carbonate) may vary and is not limited by the phosphonate and/or carbonate content or range of phosphonate and/or carbonate content. For example, the copolymer (phosphonate carbonate) may have a phosphorus content, which is indicative of the phosphonate content of from about 1% to about 20% by weight of the total copolymer (phosphonate carbonate), or the phosphorous content of the copolymer (phosphonate carbonate) of the invention may be from about 2% to about 10% by weight of the total polymer.

The copolymer (phosphonate carbonate) of various embodiments exhibits both a high molecular weight and a narrow molecular weight distribution (e.g., low polydispersity). For example, the block copolymer or random copolymer (phosphonate carbonate) may have a weight average molecular weight (Mw) of about 10,000 g/mole to about 100,000 g/mole as determined by ηᵣₑₗ or GPC, or the block copolymer or random copolymer (phosphonate carbonate) may have a weight average molecular weight (Mw) of about 12,000 g/mole to about 80,000 g/mole as determined by ηᵣₑₗ or GPC. The narrow molecular weight distribution (e.g., Mw/Mn) of such a block copolymer or random copolymer (phosphonate carbonate) may be from about 2 to about 7 or about 2 to about 5. This block copolymer or random copolymer (phosphonate carbonate) may have a relative viscosity of about 1.10 to about 1.40.

The high molecular weight distribution and narrow molecular weight distribution of the block copolymer and random copolymer (phosphonate carbonate) may impart a superior combination of properties. For example, the block copolymer and random copolymer (phosphonate carbonate) are generally tough, extremely flame-retardant, and exhibit superior hydrolytic stability. In addition, the block copolymer and random copolymer (phosphonate carbonate) exhibit an excellent combination of processing characteristics including, for example, good thermal and mechanical properties.

The blend amount of the phosphonate-containing polymer in the flame-retardant resin composition is preferably 5 to 50 parts, more preferably 10 to 40 parts by weight, with respect to 100 parts by weight of the thermosetting resin.

Examples of thermosetting resins that are used in the flame-retardant resin composition include epoxy resins and phenol resins. Epoxy resins are particularly preferred form the standpoint of adhesion with respect to metal foils or films and stability in a semi-cured state (known as the B-stage).

Examples of epoxy resins that may be used include epoxy resins that have at least two epoxy groups per molecule and do not contain halogen. Specific examples that may be cited include bisphenol epoxy resins (e.g., bisphenol A, bisphenol F, and bisphenol S resins), novolak epoxy resins (e.g., phenol novolak and cresol novolak resins), biphenyl epoxy resins, naphthalene ring-containing epoxy resins, and aliphatic epoxy resins. From the standpoint of improving flame retardancy, bisphenol F epoxy resins, bisphenol S epoxy resins, and novolak epoxy resins are preferred.

The epoxy resins described above may be used in conjunction with phosphorus-containing epoxy resins. In addition, phosphorus-containing epoxy resins may be used instead of epoxy resins. Moreover, phosphorus-containing epoxy resins and phosphorus-containing polymers may be used in conjunction. Phosphonate-containing epoxy resin, for example, may be obtained by allowing an oligomer represented by formula (2) below to react with at least one of the epoxy resins described above for 2 to 5 hours at 100 to 150°C.

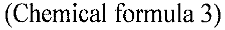

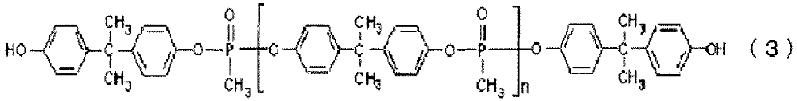

### (In formula (3), n denotes an integer of 1 to 16.)

There are no particular restrictions on the hardener, provided that it is used as a hardener for thermosetting resins. For example, when an epoxy resin is used as the thermosetting resin, the hardener is preferably used in combination with a hardener for the epoxy resin.

Specific examples of hardeners include diaminodiphenylmethane (DDM), diaminodiphenylsulfone (DDS), diaminodiphenylether (DDE), imidazole, hexamethylenediamine, polyamidoamine, dicyan diamide, and phenol novolak. In particular, from the standpoint of reaction stability, amine-based hardeners and phenol-based hardeners are preferred, with amine-based hardeners being particularly preferred. An oligomer of formula (2) may be used as a phenol-type hardener. In this case, it is preferable to use an imidazole that will serve as the epoxy resin polymerization catalyst in conjunction. As a result, the phosphorus content in the resin composition will increase, allowing a further increase in flame retardancy.

The blend amount of hardener in the flame-retardant resin composition is preferably 1 to 200 parts by weight, more preferably 3 to 100 parts by weight, with respect to 100 parts by weight of the thermosetting resin. A curing accelerator may be used in conjunction as necessary with these hardeners.

From the standpoint of improving flexibility and adhesion, flexibilizing agents are preferably added to the flame-retardant resin composition. Examples of flexibilizing agents that may be cited include acrylonitrile butadiene rubber (NBR), styrene butadiene rubber (SBR), acrylate butadiene rubber (ABR), acrylic rubber (ACM, ANM) and other synthetic rubbers, as well as polyester resin, polystyrene resin (PS), polyether sulfone resin (PES), polyurethane resin (PU), polyamide resin (PA), and other thermoplastic resins.

The blend amount of flexibilizing agent in the flame-retardant resin composition is preferably 3 to 80 parts by weight, more preferably 5 to 60 parts by weight, with respect to 100 parts by weight of thermosetting resin.

In addition, flame retardants other than the phosphonate-containing polymer may be added to the flame-retardant resin composition in order to improve handling (e.g., control tack) when the resin composition is made to assume a semi-cured state (B-stage state), in order to improve adhesion of the resin composition subsequent to curing, and in order to facilitate adjustment of melt viscosity. Examples of flame retardants that may be cited include metal hydrates such as aluminum hydroxide and magnesium hydroxide, metal carbonates such as calcium carbonate, and other such metal-containing flame retardants.

The blend amount of metal-containing flame retardant in the flame-retardant resin composition is 10 to 200 parts by weight, preferably 20 to 150 parts by weight, with respect to 100 parts by weight of the thermosetting resin. As a result, the electrical characteristics and adhesion of the resin composition subsequent to curing can be improved. In addition, when used in a coverlay, the resin composition can be fully transferred between the circuits, allowing an improvement in flame retardancy.

In addition to the various components mentioned above, various types of additives (e.g., antioxidants, surfactants, and coupling agents) may also be added, as required, to the flame-retardant resin composition in ranges that do not compromise its various characteristics.

The flame-retardant resin composition is used after curing thereof at the time of use (in particular, when used in the above applications). The extent to which the resin composition is cured is determined in accordance with the application, equipment, and the like. Normally, the composition is used after curing under prescribed conditions of heating, pressure, and the like. In terms of prescribed conditions, a temperature of 130 to 180°C is preferred, a pressure of 2 to 5 MPa/cm² is preferred, and a time of 10 to 60 min is preferred.

### (Flexible printed wiring board metal-clad laminate)

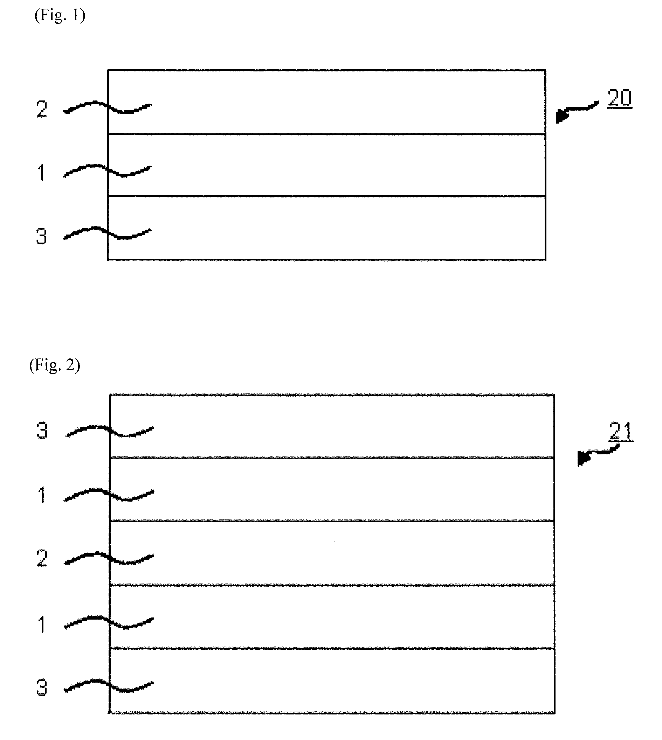

The flexible printed wiring board metal-clad laminate of the present invention, as shown in Fig. **1****,** is a laminate **20** that is produced by the lamination of a film **2** and a metal foil **3,** where the flame-retardant resin composition **1** described above is used as an adhesive for gluing the film **2** and the metal foil **3.** Fig. 1 is a schematic sectional view that shows an embodiment **20** (one-sided metal-clad laminate) of the metal-clad laminate pertaining to the present invention. The metal-clad laminate of the present invention corresponds to a substrate that is used for flexible printed wiring boards.

With the metal-clad laminate of the present invention, the film thickness is 4 to 75 µm, and the thickness of the layer that is composed of the flame-retardant resin composition that is used as adhesive is preferably 5 to 30 µm.

In another embodiment of the metal-clad laminate of the present invention, as shown in Fig. 2, the laminate **21** is produced by laminating a pair of metal foils **3, 3** to both surfaces of the film **2.** The flame-retardant resin composition **1, 1** is used as an adhesive for gluing the metal foils **3, 3** to both surfaces of the film **2.** Fig. 2 is a schematic sectional view showing another embodiment **21** (two-sided metal-clad laminate) of the metal-clad laminate pertaining to the present invention.

Examples of the film that is used include a polyimide film, polyester film, and polyamide film. Among these, a polyimide film is preferred from the standpoint of flame retardancy, electrical insulation, heat resistance, and elastic modulus. Films made from other materials may also be used.

In addition, for example, a conductive material such as metal copper foil or silver foil may be used as the metal foil.

Polyimide film is used as the film **2** in the metal-clad laminates **20, 21** shown in Figs. 1 and 2, and copper foil is used as the metal foil **3.**

### (Coverlay)

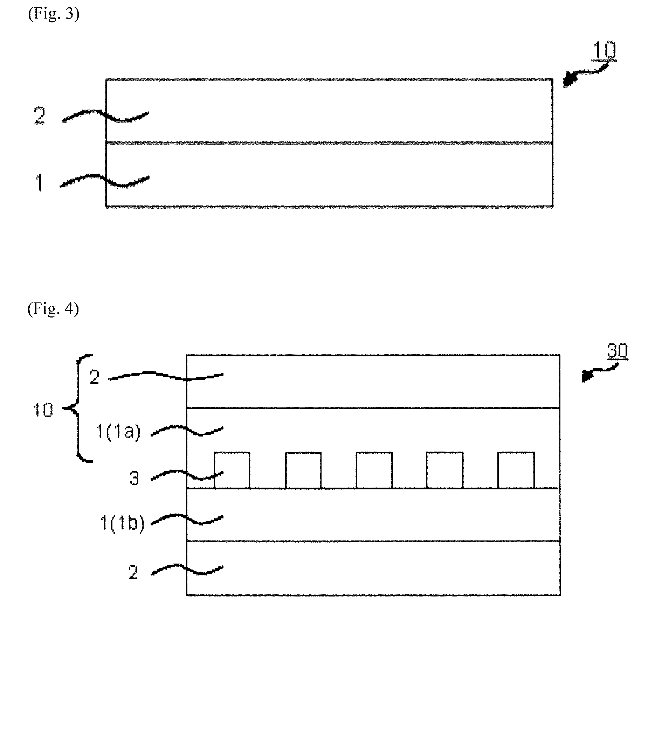

The coverlay of the present invention, as shown in Fig. 3, is produced by providing the flame-retardant resin composition **1** described above on a synthetic resin film **2** having electrical insulation properties. Fig. 3 is a schematic sectional view showing an embodiment **10** of the coverlay of the present invention.

Examples of the coverlay of the present invention that may be cited are coverlays having a configuration in which the flame-retardant resin composition described above is applied in the form of a laminate to a synthetic resin film having electrical insulation properties. This type of coverlay is used as a material that is provided in order to protect circuits, such as with a flexible printed wiring board metal-clad laminate that has circuits.

With the coverlay of this embodiment, the thickness of the synthetic resin film is 4 to 75 µm, and the thickness of the layer composed of flame-retardant resin composition is preferably 5 to 50 µm.

Examples of synthetic resin films that may be cited include polyimide films, polyester films, and polyamide films, with polyimide films being preferred among them from the standpoint of flame retardancy, electrical insulation, heat resistance, and elastic modulus.

A polyimide film is used as the film **2** in the coverlay **10** shown in Fig. 3, and the flame-retardant resin composition **1** that is provided on the film **2** functions as an adhesive. The adhesive that is used herein may be the same as, or different from, the adhesive that is used in the metal-clad laminate as described above.

### (Flexible printed wiring board adhesive sheet)

The flexible printed wiring board adhesive sheet of the present invention is composed of the flame-retardant resin composition described above and has the form of a sheet. Specifically, the flame-retardant resin composition is applied to the mold-release surface of a mold release film to produce a sheet-form adhesive sheet that is in a semi-cured state.

The thickness of the adhesive sheet of the present invention is preferably 10 to 60 µm. The adhesive sheet of the present invention is a sheet that can be used when adhering metal foils, films, metal foils with composites composed of glass fiber and thermosetting resin, or films with these composites.

### (Flexible printed wiring board)

Fig. 4 is a schematic sectional view showing an embodiment **30** (one-sided board) of the flexible printed wiring board pertaining to the present invention. As shown in Fig. 4, a one-sided flexible printed wiring board **30** is produced by laminating a coverlay **10** having a flame-retardant resin composition **1 (1a)** on a film **2** to a one-sided metal-clad laminate **20** composed of a film **2,** a flame-retardant resin composition **1 (1b),** and a metal foil **3** on which circuits are formed, so that the surface of the flame-retardant resin composition **1 (1a)** is in contact with the metal foil **3.** In this embodiment, formation of the circuits can be carried out by an etching process.

The overall thickness of the flexible printed wiring board of the present invention can be set as desired in accordance with the application.

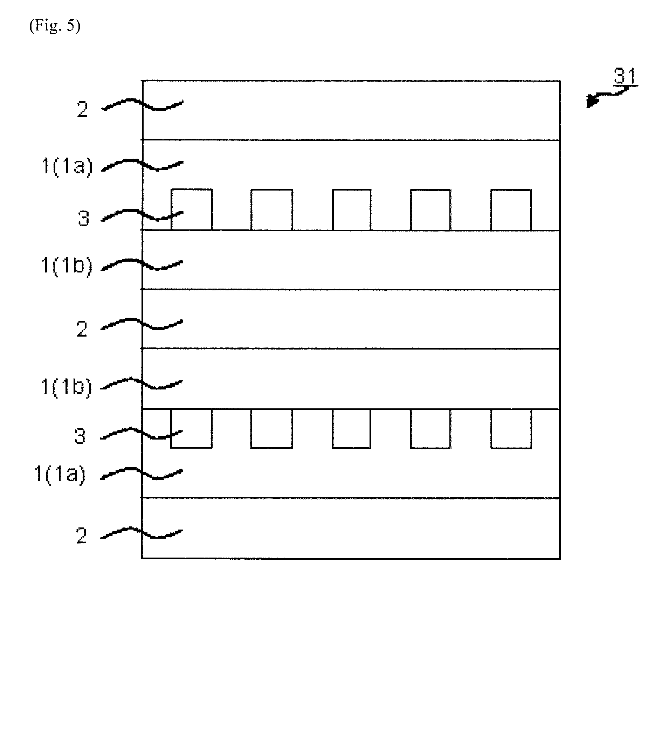

Fig. 5 is a schematic sectional view showing another embodiment **31** (two-sided board) of the flexible printed wiring board pertaining to the present invention. As shown in Fig. 5, a flexible printed wiring board **31** is obtained by using, as a substrate for the wiring board, a two-sided metal-clad laminate **21** wherein the flame-retardant resin composition **1 (1b), 1 (1b)** is provided as adhesive on both surfaces of the film **2,** with the film **2** being disposed in the middle, and metal foils **3, 3** are provided to the outside thereof. The desired circuits are then formed in the metal foils **3, 3** of the laminate **21** by an etching treatment, whereupon the coverlay composed of a film **2** and the flame-retardant resin composition **1** used as adhesive is laminated to the metal foils **3, 3** serving as circuits, so that the surface of the flame-retardant resin composition **1** is in contact therewith.

In a preferred mode of the flexible printed wiring board of the present invention, the coverlay described above and the flexible printed wiring board metal-clad laminate on which circuits have been formed are glued together by hot-pressing. In this case, preferred hot-pressing conditions are a temperature of 130 to 180°C, a pressure of 2 to 5 MPa, and a time of 10 to 60 min.

The flexible printed wiring board of the present invention is desirable for use, for example, in so-called "chip-on-flex" applications on flexible printed wiring boards for mounting IC chips.

With the flexible printed wiring boards **30, 31** shown in Figs 4 and 5, polyimide film is used as the film **2,** and copper foil is used as the metal foil **3** for producing the circuits. In addition, the adhesive in the printed wiring boards **30, 31** is the flame-retardant resin composition **1,** and the same or different blend compositions may be used for each. The flexible printed wiring board of the present invention is not restricted to these embodiments, and examples include multilayer printed wiring boards in which layers having the configurations described above are laminated in multiple layers.

Working examples of the present invention are provided below in order to describe the present invention in additional detail, but the invention is not in any way restricted by these working examples.

### (Examples 1 to 16, Comparative Examples 1 to 5)

The compounds shown in Tables 1 and 2 were each prepared. The values indicated for parts reflect the solid content equivalent. The examples shown in Tables 3 and 4 were made using different flame retardants as indicated in the Tables.

**(Table 1)**

| | Comparative Example 1 | Comparative Example 2 | Comparative Example 3 |
|---|---|---|---|
| Epoxy resin | 100 | 100 | 100 |
| Hardener | 20 | 20 | 20 |
| Flexibilizing agent | 30 | - | 15 |
| Metal-containing flame retardant | - | 30 | 15 |
| Phosphorus content (wt%) | - | - | - |
| Flame retardancy | × | × | × |
| Heat resistance | ○ | ○ | ○ |
| Migration resistance | ○ | ⊙ | ○ |

**(Table 2)**

| | Ex 1 | Ex 2 | Ex 3 | Ex 4 | Ex 5 | Ex 6 | Ex 7 | Ex 8 | Ex 9 | Ex 10 | Ex 11 | Ex 12 |
|---|---|---|---|---|---|---|---|---|---|---|---|---|
| Epoxy resin | 100 | 100 | 100 | 100 | 100 | 100 | - | 50 | 100 | 100 | 100 | 100 |
| FRX-100 | 20 | 40 | 10 | 20 | 20 | 20 | - | - | - | - | - | 10 |
| FRX CO95 | - | - | - | - | - | - | - | - | 20 | - | - | - |
| FRX CO60 | - | - | - | - | - | - | - | - | - | 20 | - | - |
| FRX CO35 | - | - | - | - | - | - | - | - | - | - | 20 | 10 |
| Phosphorus-containing epoxy resin | - | - | - | - | - | - | 100 | 50 | - | - | - | - |
| Hardener | 20 | 20 | 20 | 20 | 20 | 20 | 20 | 20 | 20 | 20 | 20 | 20 |
| Flexibilizing agent | - | - | - | 30 | - | 15 | - | - | - | - | - | - |
| Metal-containing flame retardant | - | - | - | - | 30 | 50 | - | - | - | - | - | -- |
| Phosphorus content (wt%) | 1.54 | 2.70 | 0.83 | 1.27 | 1.54 | 1.39 | 3.42 | 1.71 | 1.42 | 0.92 | 0.54 | 1.04 |
| Flame retardancy | ⊙ | ⊙ | ○ | ○ | ⊙ | ⊙ | ⊙ | ⊙ | ⊙ | ○ | × | ○ |
| Heat resistance | ⊙ | ⊙ | ⊙ | ○ | ○ | ○ | ⊙ | ⊙ | ⊙ | ⊙ | ○ | ⊙ |
| Migration resistance | ⊙ | ⊙ | ⊙ | ⊙ | ○ | ⊙ | ○ | ⊙ | ⊙ | ⊙ | ⊙ | ⊙ |

**(Table 3)**

| | Comparative Example 4 | Example 13 | Example 14 | Example 15 |
|---|---|---|---|---|
| Flame retardant resin | Commercial | FRX-100 | FRX-L 100 | FRX C095 |
| Phosphorus content (wt%) | 4.6 | 1.08 | 10.8 | 10.6 |
| Mw (GPC, PS standards) | 40,000 | 80,000 | 31,000 | 43,000 |
| Flame retardancy (UL-94-V0 [Number of passes]) | 1 of 5 | 5 of 5 | 5 of 5 | 5 of 5 |
| Loop stiffness (mN/25mm) | 40 | 50 | 24 | 40 |
| Soldering resistance (°C) | 320 | 288 | 300 | 288 |

**(Table 4)**

| | Comparative Example 5 | Example 16 |
|---|---|---|
| Flame retardant resin | Commercial | FRX OL5000 |
| Mw (GPC, PS standards) | 686 | 8,100 |
| Peel strength (N/m) | 16.5 | 16.8 |
| Flame retardancy (UL-94-VTM-0 [Number of passes]) | Pass 5 out of 5 | Pass 5 out of 5 |
| Migration Resistance | <100hrs | >250hrs |

The data in Table 1 show that a non flame-retardant epoxy resin does not exhibit any flame retardancy. When using only metal-containing flame retardant (with or without flexibilizing agent), it was not possible to achieve flame retardancy.

Table 2 shows the use of phosphonate-containing polymers (FRX-100), phosphonate-containing copolymers (FRX CO-35, FRX CO-60, and FRX CO-95), or oligomers (FRX-OL1001-based phosphonate-containing epoxy resin). FRX-100 is a phosphonate polymer having the structure shown in Formula 1. FRX CO-35, FRX CO-60, and FRX CO-95 are random copolymers comprising diphenyl carbonate, diphenylmethylphosphonate, and bisphenol A together with different weight percentages of phosphonate. Phosphonate-containing portions of the copolymers have the structure shown in Formula 1. FRX (OL1001) is an oligomeric version of FRX-100, with a smaller degree of polymerization than FRX-100 and having the structure shown in Formula 3. Using the correct structures containing these materials, it is possible to obtain materials that fulfill the requirements for flame retardancy, heat resistance, and migration resistance.

The data in Table 3 show that by using polyphosphonate compounds as the flame retardant component in the compositions, it is possible to obtain an optimized characteristics profile of the flexible printed wiring board, these characteristics passing the FR test, having a desired low loop stiffness (lower is better) and having solder float heat resistance (at least 288°C is required) such as to be adequate for the application. Surprisingly, a decrease in molecular weight of the phosphonate-containing material (from 80,000 to 30,000 g/mole (polystyrene standards)) improves the loop stiffness.

The data in Table 4 show that by using a relatively high molecular weight flame retardant compound in the formulation, the migration resistance of the composition can be considerably improved.

In order to balance all the characteristics for the final application (e.g. low loop stiffness combined with excellent migration resistance), an optimum molecular weight is required that will be between 2,000 and 40,000 g/mole.

The details of the components in Tables 1 to 4 are as follows. Epoxy resin: Bisphenol-type epoxy resin with an epoxy equivalent weight of 170 g/eq (solid content 100%).
Phosphonate-containing polymer: FRX-100 (manufactured by FRX Polymers, solid content 100%, phosphorus content 10.8 wt%, molecular weight (Mw) 30,000 to 200,000 g/mole (polystyrene standards), glass transition temperature 100°C to 107°C); FRX-CO95 (manufactured by FRX Polymers, solid content 100%, phosphorus content 10.1 wt%, molecular weight (Mw) 30,000 to 100,000 g/mole (polystyrene standards), glass transition temperature 100°C to 107°C); FRX CO-60 (manufactured by FRX Polymers, solid content 100%, phosphorus content 6.4 wt%, molecular weight (Mw) 30,000 to 100, 000 g/mole (polystyrene standards), glass transition temperature 115°C to 125°C); FRX-CO35 (manufactured by FRX Polymers, solid content 100%, phosphorus content 3.7 wt%, molecular weight (Mw) 30,000 to 100,000 g/mole (polystyrene standards), glass transition temperature 125°C to 135°C); FRXL100 (manufactured by FRX Polymers, solid content 100%, phosphorus content 10.8 wt%, molecular weight (Mw) 25,000 to 45,000 g/mole (polystyrene standards), glass transition temperature 100°C to 107°C); FRX-OL5000 (manufactured by FRX Polymers, solid content 100%, phosphorus content 10.5 wt%, molecular weight (Mw) 8,000 to 10,000 g/mole (polystyrene standards), glass transition temperature 85°C to 95°C). In the tables, the phosphorus content (wt%) is a percentage value determined by dividing the amount of phosphorus contained in the phosphorus-containing polymer by the total amount of the thermosetting resin (solid content equivalent), hardener (solid content equivalent), and phosphorus-containing polymer (solid content equivalent).
Phosphorus-containing epoxy resin: The resins indicated below were used.
Hardener: Diaminodiphenylmethane (DDM, solid content 100%).
Flexibilizing agent: Nipol 1072 (manufactured by Nippon Zeon, solid content 100%).
Metal-containing flame retardant: Aluminum hydroxide (Higilite H43STE, manufactured by Showa Denko K.K.).

### (Preparation of phosphorus-containing epoxy resin)

The phosphorus-containing epoxy resin was prepared by weighing 550 g of bisphenol A epoxy resin (JER 828, manufactured by Mitsubishi Kagaku) with an epoxy equivalent weight of 188 g/eq and 450 g of phosphorus-containing oligomer (FRX OL 1001, manufactured by FRX Polymers, solid content 100%, phosphorus content 8 to 10 wt%, Mw 2,000 to 4,500 g/mole (polystyrene standards)) into a 2-L separable flask, then stirring the materials while heating at 130°C. 2.5 g of triphenylphosphine was then added, and the materials were stirred while heating for approximately 3 hours to obtain a phosphorus-containing epoxy resin with an epoxy equivalent weight of about 510 g/eq and a phosphorus content of about 4.1 mass%.

### (Flame retardancy (UL-94-V0))

Resin sheet samples were prepared from the respective resin compositions in accordance with the UL94 standard. The curing conditions for the sheet samples were adjusted to produce a C-stage state (completely cured state). The curing conditions were as follows.

### (1) Heating temperature: 180°C, (2) Time: 60 min.

Flame retardancy was evaluated using the following criteria based on whether or not the material reached the V-0 grade in accordance with the UL94 standard.
⊙: UL94 V-0 grade completely satisfied (superior flame retardancy).
○: UL94 V-0 grade mainly satisfied (no practical issues).
×: UL94 V-0 grade not satisfied (practical issues).

### (Heat resistance)

Heat resistance was evaluated by producing samples for evaluation from the respective resin compositions. The evaluation method was carried out as prescribed by IPC TM650.
⊙: Solder float heat resistance of 300°C or greater, no practical issues.
○: Solder float heat resistance of 288°C or greater, practical use possible.
×: Solder float heat resistance lower than 288°C, insufficient heat resistance.

The samples for evaluation were produced by the following procedure. First, the respective resin compositions were applied onto a polyimide film (Apical 25NPI, manufactured by Kanegafuchi Chemical Industry) using a bar coater to produce a dried thickness of 10 µm. After heating and drying for 5 min at 150°C to produce a B-stage state (semi-cured state), the roughened surface of an electrolytic copper foil (3EC-3, 18 µm, manufactured by Mitsui Mining and Smelting) was glued to the resin composition surface using a laminator to produce a one-sided board, which was then cured to a C-stage state for 1 hour at 180°C, thereby producing a sample.

### (Migration resistance)

The migration resistance was tested under prescribed conditions (voltage: 100 V, temperature: 85°C, humidity: 85% RH), and evaluation was carried out based on the change in voltage over a constant time period (1000 hrs). The migration resistance was evaluated based on the following criteria.
⊙: Resistance of 1.0 × 10¹⁰ or greater (superior migration resistance).
○: Resistance of 1.0 × 10⁷ or greater and less than 1.0 × 10¹⁰ (no practical issues).
×: Resistance of less than 1.0 × 10⁷ (practical issues).

### (Loop stiffness)

Measured in accordance with JPCA-TM0002

### (Soldering resistance)

Measured in accordance with IPC TM650.

### (Peel strength)

The 90° peel strength was measured using an autograph AGS-500 produced by Shimadzu as the measurement apparatus. The conditions involved pulling a base film, the test speed was 50 mm/min, and the test was carried out at room temperature.

### (Flame retardancy (UL-94-VTM-0))

Resin sheet samples of the respective resin compositions were produced in accordance with the UL94 standard. The samples were prepared in a C-stage cured state (completely cured state). The curing conditions were as follows.

### (1) Heating temperature: 180°C, (2) Time: 60 min.

The flame retardancy (UL-94-VTM-0) was used to confirm whether or not the VTM-0 grade of the UL94 standard could be attained.

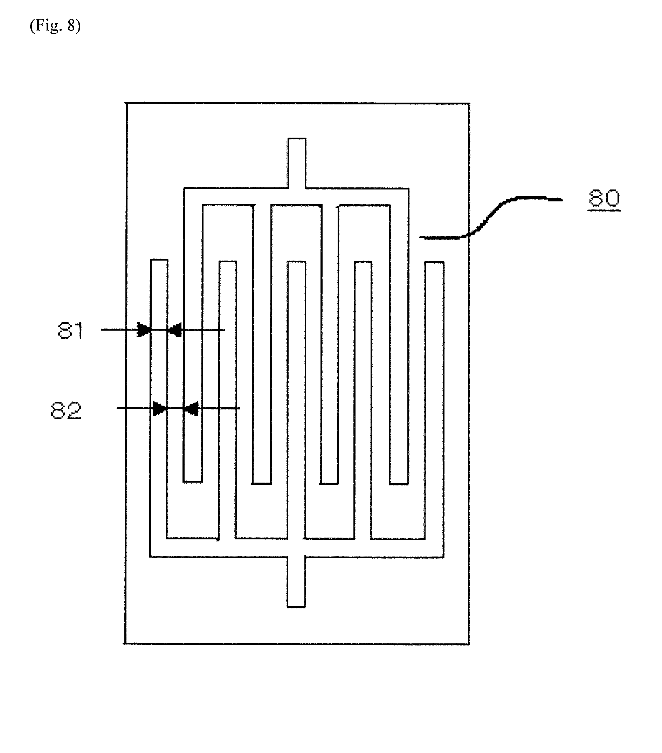

Samples for evaluation were produced by the procedure described below. First, the one-sided copper-clad laminate shown in Fig. 7 was prepared, and the circuit pattern shown in Fig. 8 was produced in the copper foil surface of the laminate by an etching treatment to obtain a one-sided copper-clad laminate having circuits. The one-sided copper-clad laminate had the same configuration as used in the heat resistance test described above. Next, respective resin compositions were prepared based on Table 1, and the respective resin compositions were applied onto polyimide films using a bar coating method so that the applied thickness after heating and drying was 25 µm. Coverlays were thus obtained in which the resin composition was in a semi-cured state (B-stage state). The conditions for producing the semi-cured state were 1 hour and 180°C. These laminates and coverlays were used, and the respective coverlays were laminated onto the circuit pattern of the one-sided copper-clad laminate. The materials were then hot-pressed for 1 hour under conditions of 180°C and 3 MPa/cm² to obtain respective flexible printed wiring boards as samples for evaluation.

The pattern for evaluating migration was a comb-shaped pattern with an L/S (line/space) ratio of 100/100.

Migration (also referred to as "copper migration") refers to a phenomenon in which the application of voltage between copper foil circuits causes elution of copper ions from the positive electrode and deposition of copper at the negative electrode with ionic impurities in the adhesive serving as a medium. Increasing deposition of this type is reflected by a decrease in resistance value between the circuits.

In accordance with the experimental results obtained in the various examples described above, the flame-retardant resin composition of the present invention was confirmed to have superior flame retardancy subsequent to curing and molding when used as a printed wiring board adhesive, while also providing superior adhesion and printed wiring board electrical characteristics.

**(EXPLANATION OF THE REFERENCES)**

| | | | |
|---|---|---|---|
| 1 | Flame-retardant resin composition | 45 | Adhesive sheet |
| | | 46 | Rigid substrate |
| 2 | Film | 48 | Through-hole |
| 3 | Metal foil | 70 | One-sided copper-clad laminate |
| 10 | Coverlay | 71 | Copper foil |
| 20, 21 | Metal-clad laminate | 72 | Adhesive |
| 30, 31 | Flexible printed wiring board | 73 | Polyimide film |
| 40 | Flex-rigid printed wiring board | 80 | Circuit pattern |
| 41 | Copper-clad laminate | 81 | Line |
| 42,47 | Circuit | 82 | Space |
| 43 | Coverlay | | |
| 44 | FPC | | |

## Claims

1. A flame-retardant resin composition comprising a thermosetting resin, a hardener, and a phosphonate-containing polymer with a molecular weight of more than 9,000 (polystyrene standards), or a glass transition temperature of at least 100°C, or a weight percentage of phosphorus of no greater than 12%.

2. The flame-retardant resin composition according to claim 1, wherein the thermosetting resin is an epoxy resin.

3. The flame-retardant resin composition according to claim 1 or 2, wherein the phosphonate-containing polymer comprises structural units represented by formula (1) below. 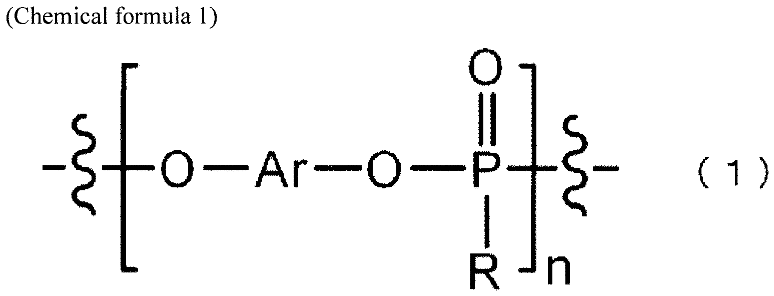 (In formula (1), Ar is any aromatic group-containing structure and -O-Ar-O- is derived from a group consisting of resorcinol, hydroquinone, biphenol, or bisphenol, R is a C1-20 alkyl, C2-20 alkene, C2-20 alkyne, C5-20 cycloalkyl, or C6-20 aryl, and n is an integer from 1 to about 300, and the phosphorus in the phosphonate-containing polymer is contained at 12 wt% or less.)

4. The flame-retardant resin composition according to claim 3, wherein -O-Ar-O- is derived from a group consisting of bisphenol A, bisphenol F, 4,4'-bisphenol, phenolphthalein, 4,4'-thiodiphenol, 4,4'-sulfonyldiphenol, 3,3,5-trimethylcyclohexyldiphenol, and combinations thereof.

5. The flame-retardant resin composition according to claim 1, 2 or 3, wherein the phosphonate-containing polymer comprises structural units represented by formula (2) below. 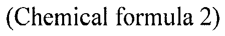 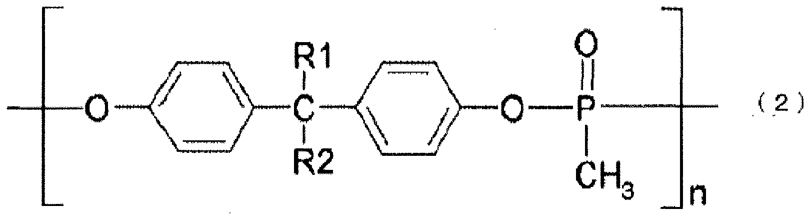 (In formula (1), R1 and R2 may be the same or different and denote hydrogen atoms or methyl groups, and n is an integer of 1 to 300.)

6. The flame-retardant resin composition according to any of claims 1 to 5, **characterized in that** a flexibilizing agent is further added, where the flexibilizing agent is selected from one or more of a synthetic rubber and a thermoplastic resin.

7. The flame-retardant resin composition according to any of claims 1 to 6, **characterized in that** a flame-retardant is further added, where the flame-retardant agent is selected from one or more of a metal hydrate and a metal carbonate.

8. A flexible printed wiring board metal-clad laminate, **characterized in that** the flame-retardant resin composition according to any of claims 1 to 7 is used as an adhesive for gluing a film and a metal foil.

9. A coverlay, **characterized in that** the flame-retardant resin composition according to any of claims 1 to 7 is provided on at least one surface of a synthetic resin film having electrical insulating properties.

10. A flexible printed wiring board adhesive sheet, **characterized by** comprising the flame-retardant resin composition according to any of claims 1 to 7.

11. A flexible printed wiring board **characterized in that** a coverlay is formed from the flame-retardant resin composition according to any of claims 1 to 7, and the coverlay is provided on a metal foil.

12. A flexible printed wiring board metal-clad laminate in which a flame-retardant resin composition is used in order to bond a film and a metal foil, and the flame-retardant resin composition includes a phosphorus-containing polymer having structural units represented by formula (1) below. 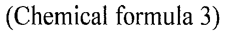 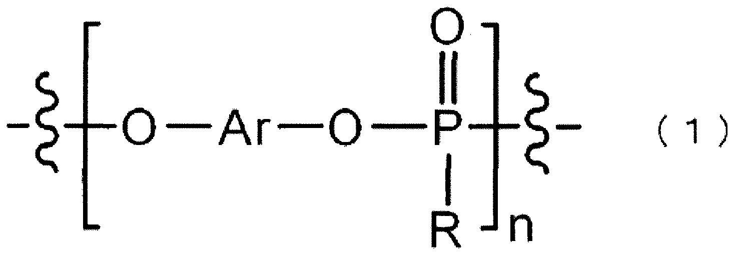 (In formula (1), Ar is any aromatic group-containing structure and -O-Ar-O- is derived from a group consisting of resorcinol, hydroquinone, biphenol, or bisphenol, R is a C1-20 alkyl, C2-20 alkene, C2-20 alkyne, C5-20 cycloalkyl, or C6-20 aryl, and n is an integer from 1 to about 300, and the phosphorus in the phosphonate-containing polymer is contained at 12 wt% or less.)

13. The flame-retardant resin composition according to claim 12, wherein -O-Ar-O-is derived from a group consisting of bisphenol A, bisphenol F, 4,4'-bisphenol, phenolphthalein, 4,4'-thiodiphenol, 4,4'-sulfonyldiphenol, 3,3,5-trimethylcyclohexyldiphenol, and combinations thereof.

14. A flexible printed wiring board adhesive sheet comprising a heat-resistant resin composition for preventing migration out of a circuit pattern on the flexible printed wiring board.

15. A flexible printed wiring board adhesive sheet comprising a heat-resistant resin composition containing a heat-resistant polymer which has a molecular weight higher than 2,000 (polystyrene standards).

16. A flexible printed wiring board metal-clad laminate comprising a heat-resistant resin composition containing a heat-resistant polymer which has a molecular weight higher than 2,000 (polystyrene standards).

17. A flexible printed wiring board adhesive sheet comprising a heat-resistant resin composition containing a heat-resistant polymer which has a molecular weight between 2,000 and 40,000 (polystyrene standards).

18. A flexible printed wiring board metal-clad laminate comprising a heat-resistant resin composition containing a heat-resistant polymer which has a molecular weight between 2,000 and 40,000 g/mole (polystyrene standards).
